# EUROPEAN PATENT APPLICATION

(11) **EP 4 773 183 A1**
(43) Date of publication of application: **08.07.2026**
(21) Application number: 24858107.6
(22) Date of filing: 16.07.2024
(51) Int. Cl.: H01L 23/31, H01L 23/552, H01L 21/50, H01L 21/56, H03H 3/08, H03H 9/10

(54) **CHIP PACKAGING STRUCTURE AND PREPARATION METHOD THEREFOR**

(30) Priority: 31.08.2023 CN 202311115215
(71) Applicant: Vanchip (Tianjin) Technology Co. Ltd, Tianjin 300457 (CN)
(72) Inventor: HONG, Shengping, Tianjin 300457 (CN); LIN, Hongkuan, Tianjin 300457 (CN); ZHOU, Bin, Tianjin 300457 (CN); YU, Caixiang, Tianjin 300457 (CN); PENG, Yanjun, Tianjin 300457 (CN)
(74) Representative: Patentship Patentanwaltsgesellschaft mbH
(86) International application number: PCT/CN2024/105638
(87) International publication number: WO 2025/044563

(57) **Abstract**

The present invention provides a chip packaging structure and a method of preparing it. The chip packaging structure includes: a substrate defining a filter chip mounting region for a filter chip and provided with a metal bonding pad at an edge of the filter chip mounting region; a metal solder layer fixed to the metal bonding pad; the filter chip, which includes a filter-chip body and a metal shield layer, the filter-chip body provided on its front side with a number of first bumps and mounted at its front side to the substrate in the filter chip mounting region, the metal shield layer covering at least a side face of the filter-chip body, wherein the metal shield layer, the metal solder layer and the metal bonding pad are interconnected so that the filter chip, the metal solder layer and the substrate together form a sealed cavity; and an encapsulation layer disposed on the substrate so as to encapsulate the filter chip. According to the present invention, the sealed cavity jointly formed by the filter chip, the metal solder layer and the substrate is prevented from ingress of an encapsulating material during the packaging process.

## Description

### TECHNICAL FIELD

The present invention relates to the field of chip packaging technology and, in particular, to a chip packaging structure and a preparation method therefor.

### BACKGROUND

Surface acoustic wave (SAW) filters have been widely used in various electronic devices thanks to their advantages of small size and good performance. A SAW filter operates based on the propagation of acoustic waves at the surface of an associated chip. Therefore, the packaging of a SAW filter is required to ensure that the surface of an interdigital transducer therein is not in contact with anything else. That is, it must be ensured that the chip surface interfaces with a hollow cavity. Otherwise, signal propagation may be adversely affected.

Conventional packaging techniques involve applying a film to all chips (a filter chip and a non-filter chip that is not a filter chip) to be incorporated in a single module so that cavities are left under the respective chips. This film, however, tends to rupture during injection molding, leading to undesirable filling of the cavity under the filter chip and hence possible failure in proper operation of the chip. In addition, the film over the non-filter chip may be ruptured inadequately, possibly leading to incomplete filling.

### SUMMARY

It is an object of the present invention to provide a chip packaging structure, in which a sealed cavity is formed between a filter chip, a metal solder layer and a substrate and is therefore prevented from undesired ingress of an encapsulating material during the packaging process, as well as a method of preparing such a structure.

The above and other objects are attained by a chip packaging structure as disclosed herein, which includes:
a substrate, wherein a metal bonding pad is arranged at an edge of a filter chip mounting region of the substrate, the filter chip mounting region being a region of the substrate for mounting a filter chip;
a metal solder layer fixed to the metal bonding pad;
the filter chip, which includes a filter-chip body and a metal shield layer, the filter-chip body having a front side and a backside, at least one first bump being arranged on the front side of the filter-chip body, the front side of the filter-chip body being attached to the filter chip mounting region of the substrate, the metal shield layer at least covering a side face of the filter-chip body, wherein the metal shield layer, the metal solder layer and the metal bonding pad are interconnected, and the filter chip, the metal solder layer and the substrate together form a sealed cavity; and
an encapsulation layer disposed on the substrate and encapsulating the filter chip.

Optionally, in the chip packaging structure, the metal shield layer may cover both the backside and the side face of the filter-chip body, wherein the metal shield layer on the backside of the filter-chip body has a thickness greater than 3 µm.

Optionally, in the chip packaging structure, the chip packaging structure may further include a non-filter chip, the non-filter chip having a front side and a backside, at least one second bump being arranged on the front side of the non-filter chip, the front side of the non-filter chip being attached to the substrate, and wherein the encapsulation layer further encapsulates the non-filter chip and fills a cavity between the non-filter chip and the substrate.

Optionally, in the chip packaging structure, there may be a plurality of second bumps.

Optionally, in the chip packaging structure, the filter chip and the non-filter chip may be mounted to the substrate so as to be spaced apart from each other.

Optionally, in the chip packaging structure, the metal bonding pad on the substrate may be annular.

Optionally, in the chip packaging structure, the metal solder layer may be annular.

Optionally, in the chip packaging structure, the metal bonding pad may be as high as the first bump.

Optionally, in the chip packaging structure, there may be a plurality of first bumps.

The above and other objects are also attained by a method of preparing a chip packaging structure as disclosed herein, which includes the steps of:
providing a substrate, wherein a metal bonding pad is arranged at an edge of a filter chip mounting region of the substrate, the filter chip mounting region being a region of the substrate for mounting a filter chip;
fixing a metal solder layer to the metal bonding pad;
providing the filter chip, which includes a filter-chip body and a metal shield layer, the filter-chip body having a front side and a backside, at least one first bump being arranged on the front side of the filter-chip body, the metal shield layer covering at least a side face of the filter-chip body, and attaching the front side of the filter-chip body to the filter chip mounting region of the substrate;
interconnecting the metal shield layer, the metal solder layer and the metal bonding pad so that the filter chip, the metal solder layer and the substrate together form a sealed cavity; and
encapsulating the filter chip by forming an encapsulation layer that encapsulates the filter chip.

Optionally, in the method, the filter chip may be formed using a process including:
providing the filter-chip body provided on its front side with the at least one first bump; and
forming the metal shield layer at least on the side face of the filter-chip body using a sputtering process.

Optionally, in the method, the metal shield layer may cover both the backside and the side face of the filter-chip body, wherein the metal shield layer on the backside of the filter-chip body has a thickness greater than 3 µm.

Optionally, in the method, the metal shield layer, the metal solder layer and the metal bonding pad may be interconnected by reflow soldering.

Optionally, the method may further include: in the step of attaching the filter-chip body at its front side to the substrate in the filter chip mounting region, providing a non-filter chip, the non-filter chip has a front side and a backside, at least one second bump being arranged on the front side of the non-filter chip, and attaching the front side of the non-filter chip to the substrate, wherein in the step of forming the encapsulation layer that encapsulates the filter chip, the encapsulation layer further encapsulates the non-filter chip and fills a cavity between the non-filter chip and the substrate.

Optionally, the metal bonding pad on the substrate may be annular.

Optionally, the metal solder layer may be annular.

The present invention has the following benefits over the prior art:
It features a metal shield layer disposed on a side face of a filter chip and a metal bonding pad disposed at an edge of a filter chip mounting region of a substrate for the filter chip. Moreover, a metal solder layer is provided on the metal bonding pad on the substrate before the filter chip is mounted. In addition, after the filter chip is mounted, the metal shield layer, the metal solder layer and the pad are interconnected so that the filter chip, the metal solder layer and the substrate together form a sealed cavity (under the filter chip). With this arrangement, the sealed cavity can be prevented from ingress of an encapsulating material during the packaging process. Otherwise, the filter chip may fail if the underlying cavity is filled.

Further, the present invention features attaching of a non-filter chip on the substrate, which is not a filter chip, at the same time as the attaching of the filter chip. According to the present invention, since the application of a film is not involved, the non-filter chip will not suffer from filling issues arising from inadequate rupture of such a film. That is, the present invention enables a cavity under the non-filter chip to be completely filled by an encapsulating material during the packaging process, providing protection for second bumps on the non-filter chip.

Furthermore, the present invention features the metal shield layer optionally covering both a side face and a backside of the filter chip. Thus, the metal shield layer, the metal solder layer and the substrate together form a shield for a body of the filter chip, which can prevent EMI of the filter-chip body with the non-filter chip.

### BRIEF DESCRIPTION OF THE DRAWINGS

Fig. 1 shows a cross-sectional view of a chip packaging structure according to an embodiment of the present invention.
Fig. 2 shows a top view of a chip packaging structure according to an embodiment of the present invention.
Fig. 3 shows a flowchart of a method of preparing a chip packaging structure according to an embodiment of the present invention.
Fig. 4 shows a cross-sectional view of an intermediate structure for a chip packaging structure embodying the present invention, which is formed as a result of step S1 being performed in a method of preparing the structure.
Fig. 5 shows a cross-sectional view of an intermediate structure for the chip packaging structure that embodies the present invention, which is formed as a result of step S2 being performed in the method.
Fig. 6 shows a cross-sectional view of an intermediate structure for the chip packaging structure that embodies the present invention, which is formed as a result of step S31 being performed in the method.
Fig. 7 shows a cross-sectional view of an intermediate structure for the chip packaging structure that embodies the present invention, which is formed as a result of step S32 being performed in the method.
Fig. 8 shows a cross-sectional view of an intermediate structure for the chip packaging structure that embodies the present invention, which is formed as a result of step S4 being performed in the method.
Fig. 9 shows a cross-sectional view of an intermediate structure for the chip packaging structure that embodies the present invention, which is formed as a result of step S5 being performed in the method.

### DETAILED DESCRIPTION

Chip packaging structures and methods proposed herein will be described in greater detail below with reference to the accompanying drawings, which illustrate specific embodiments thereof. From the following description, advantages and features of the invention will become apparent. Note that the figures are provided in a very simplified form not necessarily drawn to exact scale for the only purpose of helping to explain the disclosed embodiments in a more convenient and clearer way.

Conventional packaging techniques involve applying a film to filter and non-filter chips to be incorporated in a single module so that a cavity is left under the chips. This film, however, tends to rupture during injection molding, leading to undesirable filling of the cavity under the filter chip and hence possible failure in proper operation of the chip. On the other hand, the film over the non-filter chips may be ruptured insufficiently, possibly leading to incomplete filling.

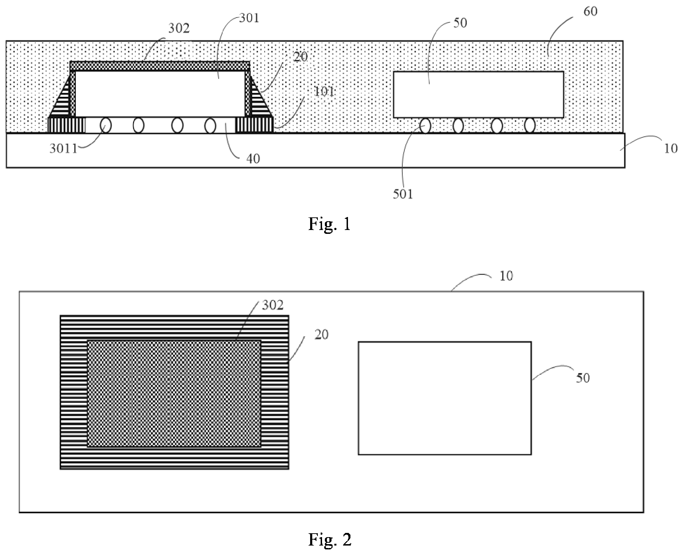

In order to overcome this problem, the present invention provides a chip packaging structure with a cavity under a filter chip, which is prevented from failure of the filter chip due to the cavity being undesirably filled. Referring to Figs. 1 and 2, a chip packaging structure as described herein includes:
a substrate 10, the substrate 10 defines a filter chip mounting region for a filter chip and provided with a metal bonding pad 101 at an edge of the filter chip mounting region, wherein the filter chip mounting region is a region of the substrate 10, where the filter chip is to be mounted;
a metal solder layer 20 fixed to the metal bonding pad 101;
the filter chip, which includes a filter-chip body 301 and a metal shield layer 302, the filter-chip body 301 having a front side and a backside and provided on the front side with a number of first bumps 3011, the front side of the filter-chip body 301 mounted to the substrate 10 in the filter chip mounting region, the metal shield layer 302 covering at least a side face of the filter-chip body 301 so as to be connected to the metal solder layer 20 and the metal bonding pad 101, wherein the filter chip, the metal solder layer 20 and the substrate 10 together form a sealed cavity; and
an encapsulation layer 60 disposed on the substrate 10 so as to encapsulate the filter chip.

In this embodiment, the substrate 10 is provided mainly to carry chips, and may contain a wiring layer. The metal bonding pad 101 is disposed on the substrate 10 and is arranged at the edge of the filter chip mounting region. In this embodiment, the metal bonding pad 101 is preferably electrically connected to the wiring layer in the substrate 10. In this embodiment, the filter chip mounting region is a region of the substrate 10, where the filter chip is to be mounted.

The metal bonding pad 101 is preferably annular in shape, and may have a height less than or equal to that of the first bumps 3011. Preferably, the height of the metal bonding pad 101 is the same as that of the first bumps 3011, allowing for concurrence of contact between the first bumps 3011 and the substrate 10 while the metal bonding pad 101 can contact the metal shield layer 302. In this embodiment, it is possible that only the metal shield layer 302 resides on the metal bonding pad 101, or that both the metal shield layer 302 and an edge portion of the front side of the filter-chip body 301 reside on the metal bonding pad 101. Here, the edge portion of the front side of the filter-chip body 301 is smaller than a portion of the filter-chip body 301 extending from the outermost ones of the first bumps 3011 to the periphery of the filter-chip body 301. That is, none of the first bumps 3011 are arranged on the edge portion of the front side of the filter-chip body 301. In this embodiment, the metal solder layer 20 is preferably made of a metal, but the present invention is not so limited. More preferably, the metal solder layer 20 is made of a metal with shielding properties, such as copper.

The metal solder layer 20 resides on the metal bonding pad 101. In this embodiment, the metal solder layer 20 is preferably annular in shape and has a width preferably less than or equal to that of the metal bonding pad 101. More preferably, the width of the metal solder layer 20 is less than that of the metal bonding pad 101, because this allows both the metal shield layer 302 and the edge portion of the front side of the filter-chip body 301 to reside on the metal bonding pad 101. In this embodiment, the metal solder layer 20 is preferably made of a metal, but the present invention is not so limited. More preferably, the metal solder layer 20 is made of a metal with shielding properties, such as copper. Even more preferably, the metal solder layer 20 is made of the same material as the metal bonding pad 101.

While it has been described above that contact of the first bumps 3011 with the substrate 10 is preferred to concur with contact of the metal bonding pad 101 with the metal shield layer 302, in practical applications, once the first bumps 3011 are brought into contact with the substrate 10, it may be difficult to further bring the metal bonding pad 101 into sufficient contact with the metal shield layer 302 due to process variations. Instead, a minor gap may be left between the metal bonding pad 101 and the metal shield layer 302, creating a risk of ingress of an encapsulating material into the sealed cavity 40 during the packaging process. According to this embodiment, the metal solder layer 20 is fixedly attached to both a side face of the metal shield layer 302 and the metal bonding pad, thereby completely sealing off any minor gap that may be present between the metal bonding pad 101 and the metal shield layer 302. This prevents the sealed cavity 40 from being undesirably filled by an encapsulating material. That is, the presence of the metal solder layer 20 can ensure the eventual formation of a completely sealed hermetic space 40.

The filter chip is mounted to the substrate 10 in the filter chip mounting region for this filter chip so as to form the sealed cavity 40 together with the metal solder layer 20 and the substrate 10. In this embodiment, the filter chip includes the filter-chip body 301 and the metal shield layer 302, and the filter-chip body 301 has the front side and the backside and is provided on the front side with the first bumps 3011. In this embodiment, the number of first bumps 3011 is preferable more than one.

The metal shield layer 302 covers at least a side face of the filter-chip body 301. In particular, the metal shield layer 302 may cover only the side face of the filter-chip body 301, or may simultaneously cover the side face and the backside of the filter-chip body 301. Preferably, the metal shield layer 302 covers both the side face and backside of the filter-chip body 301. This not only enables the formation of the sealed cavity 40, but also allows the metal shield layer 302 to form a shield for the filter-chip body 301, together with the metal solder layer 20 and the substrate 10, which can prevent electromagnetic interference (EMI) of the filter-chip body 301 with annon-filter chip. In this embodiment, the metal shield layer 302 on the backside of the filter-chip body 301 is preferred to have a thickness greater than 3 µm, and the metal shield layer 302 on the side face of the filter-chip body 301 is preferred to also have a thickness (width) greater than 3 µm. With this arrangement, enhanced hermeticity and EMI shielding properties of the resulting sealed cavity 40 can be obtained.

In this embodiment, the chip packaging structure may further include a non-filter chip 50. The non-filter chip 50 may contain a conventional electronic component operable without a cavity, such as an antenna switch, low-noise amplifier, capacitor or inductor. The non-filter chip 50 has a front side and a backside, and is provided with a number of second bumps 501 on the front side. In this embodiment, the number of second bumps 501 is preferably more than one, and the second bumps 501 have a height, which may be equal to that of the first bumps 3011, or not. The non-filter chip 50 is mounted at the front side to the substrate 10. In particular, the non-filter chip 50 may be fixed, at the front side (with the second bumps 501), to the substrate 10 in a filter chip mounting region for the non-filter chip. In this embodiment, the filter chip and the non-filter chip 50 are mounted to the substrate 10 so as to be spaced apart from each other and so that surfaces of the first bumps 3011 that face the substrate 10 are coplanar with surfaces of the second bumps 501 that face the substrate 10.

The encapsulation layer 60 is disposed on the substrate 10 and encapsulates the filter chip. Furthermore, the encapsulation layer 60 also encapsulates the non-filter chip 50 and fills a cavity (i.e., a non-sealed cavity 70) between the non-filter chip 50 (more precisely, the bottom of the non-filter chip 50) and the substrate 10. The encapsulation layer 60 may be made of an epoxy resin, a polyimide resin, a benzocyclobutene resin, a polybenzoxazole resin, polybutylene terephthalate, polycarbonate, polyethylene terephthalate, polyethylene, polypropylene, polyolefin, polyurethane, polyolefin, polyethersulfone, polyamide, polyurethane, an ethylene-vinyl acetate copolymer, polyvinyl alcohol or the like. In this embodiment, the surfaces of the first bumps 3011 that face the substrate 10 and the surfaces of the second bumps 501 that face the substrate 10 are coplanar with a surface of the encapsulation layer 60 that faces the substrate 10. Since the cavity under the filter-chip body 301 is sealed (i.e., the sealed cavity 40), the encapsulating material is prevented from entering this cavity during the packaging process. However, since the cavity under the non-filter chip 50 is not sealed (i.e., the non-sealed cavity 70), it is completely filled by the encapsulating material during the packaging process.

Compared with the prior art, the sealed cavity 40 under the filter chip can be prevented from being filled by the encapsulating material, in accordance with this embodiment. Moreover, since the application of a film is not involved, the non-filter chip will not suffer from filling issues arising from inadequate rupture of such a film, in accordance with this embodiment. That is, the cavity under the non-filter chip 50 can be completely filled, in accordance with this embodiment.

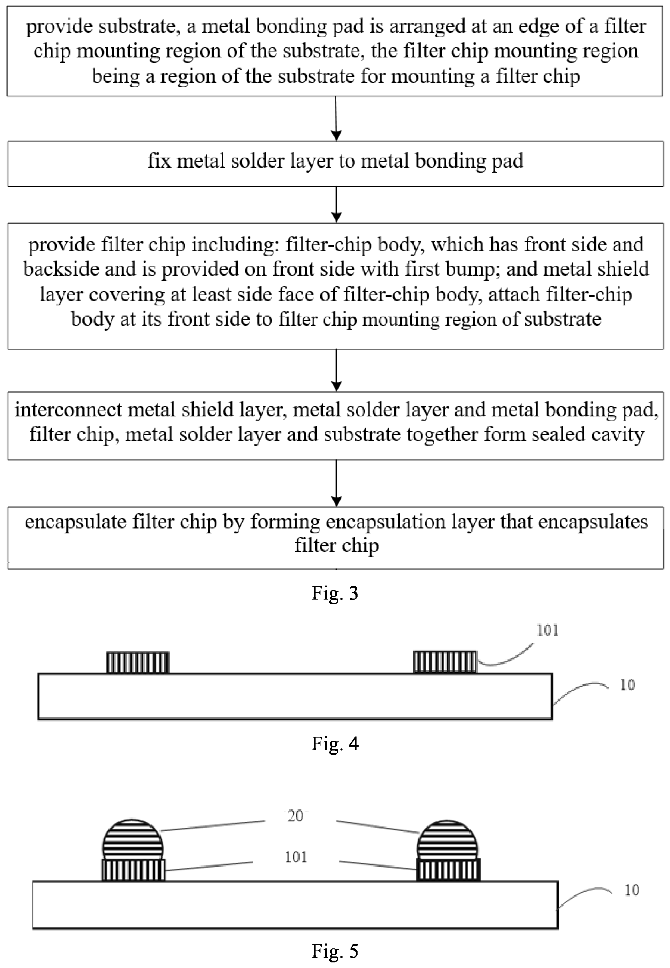

Referring to Fig. 3, such a chip packaging structure may be made according to a method including the steps of:
S1) providing a substrate 10 defining a filter chip mounting region for a filter chip and provided with a metal bonding pad 101 at an edge of the filter chip mounting region, wherein the filter chip mounting region is a region of the substrate 10, where the filter chip is to be mounted;
S2) fixing a metal solder layer 20 to the metal bonding pad 101;
S3) providing the filter chip, which includes a filter-chip body 301 and a metal shield layer 302, the filter-chip body 301 having a front side and a backside and provided on the front side with a number of first bumps 3011, the metal shield layer 302 covering at least a side face of the filter-chip body 301, and attaching the front side of the filter-chip body to the substrate in the filter chip mounting region;
S4) interconnecting the metal shield layer 302, the metal solder layer 20 and the metal bonding pad 101 so that the filter chip, the metal solder layer 20 and the substrate 10 together form a sealed cavity; and
S5) encapsulating the filter chip by forming an encapsulation layer 60 that encapsulates the filter chip.

Referring to Fig. 4, in step S1, the substrate 10 is provided. In the present embodiment, the substrate 10 is provided mainly to carry chips, and may contain a wiring layer. In this embodiment, the metal bonding pad 101 is disposed on the substrate 10. In this embodiment, the metal solder layer 20 may be formed on the substrate 10 using an electroplating, substrate, printing or other process. The metal solder layer 20 is preferably made of a metal, but the present invention is not so limited. More preferably, the metal solder layer 20 is made of a metal with shielding properties, such as copper. The metal bonding pad 101 is disposed on the substrate 10 at the edge of the filter chip mounting region so as to come into contact with the metal shield layer 302 and an edge portion of the front side of the filter-chip body 301. The metal bonding pad 101 is preferred to be annular in shape and to as high as the first bumps 3011, allowing for concurrence of contact between the first bumps 3011 and the substrate 10 with contact of the metal bonding pad 101 with both the metal shield layer 302 and the edge portion of the front side of the filter-chip body 301.

Referring to Fig. 5, in step S2, the metal solder layer 20 is formed. In this embodiment, the metal solder layer 20 is preferably formed using a printing process, but the present invention is not so limited. The metal solder layer 20 is preferred to be annular in shape and resides on the metal bonding pad 101. The metal solder layer 20 is preferably made of a metal, but the present invention is not so limited. More preferably, the metal solder layer 20 is made of a metal with shielding properties, such as copper. Even more preferably, the metal solder layer 20 is made of the same material in the same process as the metal bonding pad 101, increasing process simplicity. In alternative embodiments, the metal solder layer 20 and the metal bonding pad 101 may be made of the same material but in separate processes.

In this embodiment, the metal solder layer 20 has a width, which is preferably less than or equal to that of the metal bonding pad 101. More preferably, the width of the metal solder layer 20 is less than that of the metal bonding pad 101, because this allows both a bottom edge of a side face of the metal shield layer 302 and the edge portion of the front side of the filter-chip body 301 to reside on the metal solder layer 20.

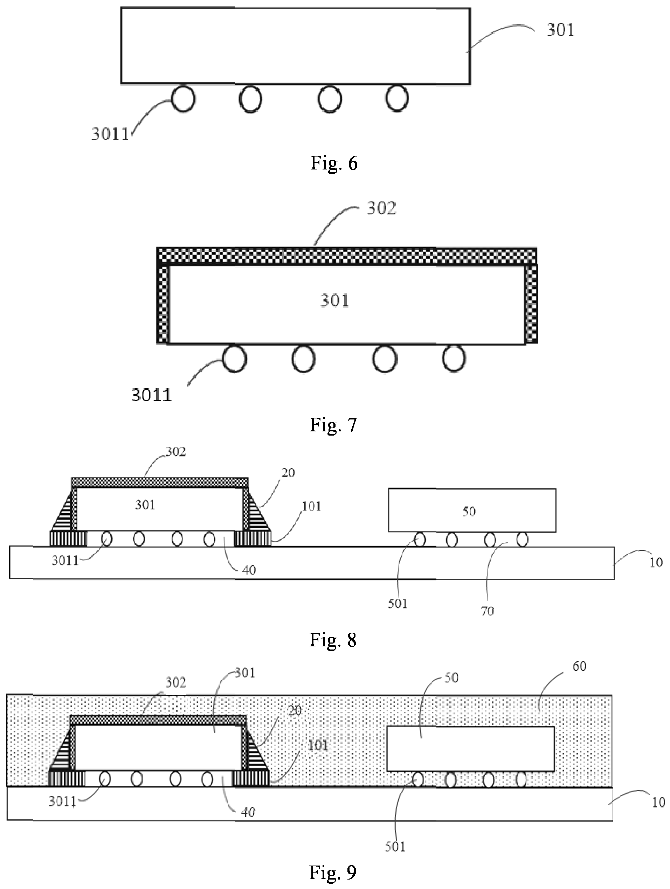

Referring to Figs. 6 to 8, in step S3, the filter chip is provided and mounted to the substrate 10. The filter chip includes the filter-chip body 301 and the metal shield layer 302. The filter chip may be made according to a method including the steps of:
S31) providing the filter-chip body 301, which is provided on its front side with a number of first bumps 3011; and
S32) forming the metal shield layer 302 at least on the side face of the filter-chip body 301 using a sputtering process.

Referring to Fig. 6, in step S31, the filter-chip body 301 is provided. The filter-chip body 301 is mounted to the substrate 10 through the first bumps 3011. The first bumps 3011 may be made of a metal or solder, and the number of first bumps 3011 is preferably more than one.

Referring to Fig. 7, in step S32, the metal shield layer 302 is formed. In this embodiment, the metal shield layer 302 is preferably formed using a sputtering process, but the present invention is not so limited. In this embodiment, the metal shield layer 302 may be formed on only the side face of the filter-chip body 301, or may simultaneously cover the side face and the backside of the filter-chip body 301. Preferably, the metal shield layer 302 covers both the side face and backside of the filter-chip body 301. This not only enables the formation of the sealed cavity 40, but also allows the metal shield layer 302 to form a shield for the filter-chip body 301, together with the metal solder layer 20 and the substrate 10 (with the metal bonding pad 101 and wiring layer), which can prevent EMI of the filter-chip body 301 with annon-filter chip. In this embodiment, the metal shield layer 302 on the backside of the filter-chip body 301 is preferred to have a thickness greater than 3 µm, and the metal shield layer 302 on the side face of the filter-chip body 301 may have a thickness greater than 3 µm.

Referring to Fig. 8, the filter-chip body 301 is fixed to the substrate 10, with its front side facing the substrate 10. In particular, the filter-chip body 301 may be flipped, and the first bumps 3011 may be soldered to the substrate 10.

With continued reference to Fig. 8, in this embodiment, in step S3, the method may further include: providing a non-filter chip 50; and attaching the non-filter chip 50 to the substrate 10. The non-filter chip 50 has a front side and a backside, and is provided with a number of second bumps 501 on the front side. The non-filter chip 50 is mounted at the front side to the substrate 10. In this embodiment, the non-filter chip 50 may be flipped, and the second bumps 501 may be soldered to the substrate 10.

With continued reference to Fig. 8, in step S4, the metal shield layer 302, the metal solder layer 20 and the metal bonding pad 101 may be interconnected by reflow soldering. In this embodiment, the metal solder layer 20 turns into a liquid in the process of reflow soldering, part of which spreads upwards on the side face of the metal shield layer 302. As a result, the metal solder layer 20 changes its shape after the reflow soldering process and is fixed to the side face of the metal shield layer 302. In this embodiment, the metal shield layer 302 on the side face of the filter-chip body 301 is soldered and connected to, so as to form the sealed cavity 40 together with, the metal solder layer 20 and the metal bonding pad 101. In addition, the metal shield layer 302 on the backside and side face of the filter-chip body is soldered and connected to, so as to form a shield, together with the metal solder layer 20 and the metal bonding pad 101.

Referring to Fig. 9, in step S5, the encapsulation layer 60 is formed. Encapsulation is a well-established process in the packaging industry, which involves using an encapsulation machine to encapsulate a chip on a substrate within an encapsulant. This can provide protection to the chip and offer a variety of advantages including high surface flatness, high hardness, high heat resistance, high reliability and low cost. In this embodiment, the encapsulation layer 60 may encapsulate both the filter chip and the non-filter chip 50. That is, in addition to the filter chip, the encapsulation layer 60 may further encapsulate the non-filter chip 50 and fill a cavity between the non-filter chip 50 and the substrate 10. Since the cavity (i.e., the sealed cavity 40) under the filter-chip body 301 is sealed, the encapsulating material is prevented from entering this cavity during the packaging process. However, since the cavity (i.e., a non-sealed cavity 70) under the non-filter chip 50 is not sealed, it is completely filled by the encapsulating material during the packaging process, providing protection for the second bumps 501. Compared with the prior art, the sealed cavity 40 under the filter chip can be prevented from being filled by the encapsulating material, in accordance with this embodiment. Moreover, since the application of a film is not involved, the non-filter chip will not suffer from filling issues arising from inadequate rupture of such a film, in accordance with this embodiment. That is, the cavity under the non-filter chip 50 can be completely filled, in accordance with this embodiment.

In conclusion, the present invention features a metal shield layer disposed on a side face of a filter-chip body and a metal bonding pad disposed at an edge of a filter chip mounting region of a substrate for a filter chip. Moreover, a metal solder layer is provided on the metal bonding pad on the substrate before the filter chip is mounted. In addition, after the filter chip is mounted, the metal shield layer, the metal solder layer and the metal bonding pad are interconnected by reflow soldering so as to together form a sealed cavity.

Further, the present invention features attaching of annon-filter chip on the substrate, which is not a filter chip, at the same time as the attaching of the filter chip. In accordance with the present invention, a cavity under the non-filter chip can be completely filled by an encapsulating material during the packaging process, providing protection for the non-filter chip.

Furthermore, the present invention features the metal shield layer optionally covering both a side face and a backside of the filter chip. Moreover, as a result of the reflow soldering process, the metal shield layer, the metal solder layer and the substrate together form a shield for the filter-chip body, which can prevent EMI of the filter-chip body with the non-filter chip.

It is to be understood that, while the present invention has been described with reference to several preferred embodiments, the forgoing embodiments are not intended to limit the invention. In light of the teachings hereinabove, any person familiar with the art may make various possible variations and changes to the disclosed embodiments or modify them into equivalent alternatives, without departing from the scope thereof. Accordingly, any and all such simple variations, equivalent alternatives and modifications made to the foregoing embodiments without departing from the scope of the invention are intended to fall within the scope thereof.

It is to be further understood that the present invention is not limited to the particular methodology, compounds, materials, fabrication techniques, uses and applications described herein, as these may vary. It is also to be understood that the terminology used herein is for the purpose of describing particular embodiments only, and is not intended to limit the scope of the present invention. It must be noted that as used herein and in the appended claims, the singular forms "a" and "an" include the plural reference unless the context clearly dictates otherwise. Thus, for example, a reference to "a step" or "a means" is a reference to one or more steps or means and may include sub-steps. All conjunctions used are to be understood in the most inclusive sense possible. Thus, the term "or" should be understood as having the definition of a logical "or" rather than that of a logical "exclusive or" unless the context clearly necessitates otherwise. Structures described herein are to be understood also to refer to functional equivalents of such structures. Language that may be construed to express approximation should be so understood unless the context clearly dictates otherwise.

## Claims

1. A chip packaging structure, comprising:
a substrate, wherein a metal bonding pad is arranged at an edge of a filter chip mounting region of the substrate, the filter chip mounting region being a region of the substrate for mounting a filter chip;
a metal solder layer fixed to the metal bonding pad;
the filter chip, comprising a filter-chip body and a metal shield layer, the filter-chip body having a front side and a backside, at least one first bump being arranged on the front side of the filter-chip body, the front side of the filter-chip body being attached to the filter chip mounting region of the substrate, the metal shield layer at least covering a side face of the filter-chip body, wherein the metal shield layer, the metal solder layer and the metal bonding pad are interconnected, and the filter chip, the metal solder layer and the substrate together form a sealed cavity; and
an encapsulation layer disposed on the substrate and encapsulating the filter chip.

2. The chip packaging structure of claim 1, wherein the metal shield layer covers both the backside and the side face of the filter-chip body, and wherein the metal shield layer on the backside of the filter-chip body has a thickness greater than 3 µm.

3. The chip packaging structure of claim 1, further comprising a non-filter chip, the non-filter chip comprising a front side and a backside, at least one second bump being arranged on the front side of the non-filter chip, the front side of the non-filter chip being attached to the substrate, and wherein the encapsulation layer further encapsulates the non-filter chip and fills a cavity between the non-filter chip and the substrate.

4. The chip packaging structure of claim 3, wherein there is a plurality of second bumps.

5. The chip packaging structure of claim 3, wherein the filter chip and the non-filter chip are mounted spaced apart to the substrate.

6. The chip packaging structure of claim 1, wherein the metal bonding pad on the substrate is annular.

7. The chip packaging structure of claim 1, wherein the metal solder layer is annular.

8. The chip packaging structure of claim 1, wherein a height of the metal bonding pad is equal to a height of the first bump.

9. The chip packaging structure of claim 1, wherein there is a plurality of first bumps.

10. A method of preparing a chip packaging structure, comprising the steps of:
providing a substrate, wherein a metal bonding pad is arranged at an edge of a filter chip mounting region of the substrate, the filter chip mounting region being a region of the substrate for mounting a filter chip;
fixing a metal solder layer to the metal bonding pad;
providing the filter chip, which comprises a filter-chip body and a metal shield layer, the filter-chip body having a front side and a backside, at least one first bump being arranged on the front side of the filter-chip body, the metal shield layer covering at least a side face of the filter-chip body, and attaching the front side of the filter-chip body to the filter chip mounting region of the substrate;
interconnecting the metal shield layer, the metal solder layer and the metal bonding pad so that the filter chip, the metal solder layer and the substrate together form a sealed cavity; and
encapsulating the filter chip by forming an encapsulation layer that encapsulates the filter chip.

11. The method of preparing the chip packaging structure of claim 10, wherein the filter chip is formed using a process comprising:
providing the filter-chip body provided on its front side with the at least one first bump; and
forming the metal shield layer at least on the side face of the filter-chip body using a sputtering process.

12. The method of preparing the chip packaging structure of claim 10, wherein the metal shield layer covers both the backside and the side face of the filter-chip body, and wherein the metal shield layer on the backside of the filter-chip body has a thickness greater than 3 µm.

13. The method of preparing the chip packaging structure of claim 10, wherein the metal shield layer, the metal solder layer and the metal bonding pad are interconnected by reflow soldering.

14. The method of preparing the chip packaging structure of claim 10, further comprising: in the step of attaching the front side of the filter-chip body to the filter chip mounting region of the substrate, providing a non-filter chip, the non-filter chip comprising a front side and a backside, at least one second bump being arranged on the front side of the non-filter chip, and attaching the front side of the non-filter chip to the substrate, wherein in the step of forming the encapsulation layer that encapsulates the filter chip, the encapsulation layer further encapsulates the non-filter chip and fills a cavity between the non-filter chip and the substrate.

15. The method of preparing the chip packaging structure of claim 10, wherein the metal bonding pad on the substrate is annular.

16. The method of preparing the chip packaging structure of claim 10, wherein the metal solder layer is annular.
